# EUROPEAN PATENT APPLICATION

(11) **EP 4 766 043 A1**
(43) Date of publication of application: **24.06.2026**
(21) Application number: 24222742.9
(22) Date of filing: 23.12.2024
(51) Int. Cl.: H05K 7/14

(54) **RACK EQUIPMENT REMOVAL TOOL**

(71) Applicant: Schneider Electric IT Corporation, Foxboro, MA 02035 (US)
(72) Inventor: ZHANG, Bosheng, SHANGHAI (CN); BAI, Bin, SHANGHAI (CN)
(74) Representative: Plasseraud IP

(57) **Abstract**

A rack equipment removal tool includes a handle and a housing having a rotation shaft. The handle is coupled to the rotation shaft and configured to rotate with respect to the housing about the rotation shaft. The rack equipment removal tool further includes a hook having a first end coupled to the handle and a second end having a fastener configured to be coupled to a power module. The rack equipment removal tool further includes a frame mounting fastener coupled to the housing. The frame mounting fastener is configured to be coupled to a frame of an equipment rack supporting the power module. Rotation of the handle causes the movement of the hook to partially remove the power module from the equipment rack.

## Description

### BACKGROUND OF THE DISCLOSURE

### 1. Field of Disclosure

The present disclosure is directed to an information technology (IT) equipment rack configured to support IT equipment, including power modules, and more particularly to a device or tool that is specifically designed to assist an operator from removing a power module from the IT equipment rack.

### 2. Discussion of Related Art

Equipment racks, sometimes referred to as IT equipment racks, are often installed with IT equipment, e.g., power modules, which are heavy and difficult to remove from the IT equipment racks. Several environmental factors make it difficult to remove a power module, especially a heavier power module (40 kilograms (kg)), from the IT equipment rack, such as the high friction force, direct friction of sheet metal on the rail of the IT equipment rack, inaccurate design tolerances between the power module and the rails of the IT equipment rack, tight connections of input and output terminals provided on the end of the power module, and the lack of wheels or lubrication under the power module to reduce friction.

### SUMMARY OF THE DISCLOSURE

One aspect of the present disclosure is directed to a rack equipment removal tool comprising a handle and a housing including a rotation shaft. The handle is coupled to the rotation shaft and configured to rotate with respect to the housing about the rotation shaft. The rack equipment removal tool further comprises a hook having a first end coupled to the handle and a second end having a fastener configured to be coupled to a power module. The rack equipment removal tool further comprises a frame mounting fastener coupled to the housing. The frame mounting fastener is configured to be coupled to a frame of an equipment rack supporting the power module. Rotation of the handle causes the movement of the hook to partially remove the power module from the equipment rack.

Embodiments of the rack equipment removal tool further may include configuring the housing to have a sliding-housing channel. The rack equipment removal tool further may include a moving link coupled to the handle and coupled to a moving block. The moving link may be configured to move within the sliding-housing channel. The handle may include a first portion configured to be gripped by an operator and a second portion that extends from the first portion and is configured to be received within the sliding-housing channel. The second portion of the handle may be pivotally coupled to the moving link by a connection shaft. The moving link may be coupled to the moving block by a first pin The first end of the hook may be coupled to the moving block by a second pin. The fastener of the hook may include a threaded fastener configured to be threadably received within a threaded opening formed in a flange of the power module. The housing may include a first tab portion configured to receive the frame mounting fastener. The first tab portion may extend along a plane that is angled with respect to a direction of the housing. The housing further may include a second tab portion spaced from the first tab portion. The second tab portion may be configured to receive another frame mounting fastener. Each of the first tab portion and the second tab portion may extend along a plane that is angled with respect to a direction of the housing.

Another aspect of the present disclosure is directed to a method of removing a power module from an equipment rack. In one embodiment, the method comprises: securing a hook of a rack equipment removal tool to the power module; securing a frame mounting fastener of the rack equipment removal tool to the equipment rack; and rotating a handle of the rack equipment removal tool about a rotation shaft configured to couple the handle to a sliding-housing channel of a housing of the rack equipment removal tool. The rotation of the handle causes the movement of the hook to partially remove the power module from the equipment rack.

Embodiments of the method further may include pivotally coupling the second portion of the handle to the moving link by a connection shaft, pivotally coupling the moving link to the moving block by a first pin, and pivotally coupling the first end of the hook to the moving block by a second pin. Rotating the handle further may cause movement of a moving link that is coupled to the handle and coupled to a moving block of the rack equipment removal tool. The hook may be coupled to the moving block. The handle may include a first portion configured to be gripped by an operator and a second portion that extends from the first portion and may be configured to be received within the sliding-housing channel. The fastener of the hook may include a threaded fastener configured to be threadably received within a threaded opening formed in a flange of the power module. The housing may include a first tab portion configured to receive the frame mounting fastener. The housing further may include a second tab portion spaced from the first tab portion, the second tab portion being configured to receive another frame mounting fastener. Each of the first tab portion and the second tab portion may extend along a plane that is angled with respect to a direction of the housing.

Yet another aspect of the present disclosure is directed to a method of removing a power module from an equipment rack. In one embodiment, the method comprises: securing a first hook of a first rack equipment removal tool to a first flange of the power module; securing a second hook of a second rack equipment removal tool to a second flange of the power module; securing a first frame mounting fastener of the first rack equipment removal tool to a first frame member of the equipment rack; securing a second frame mounting fastener of the second rack equipment removal tool to a second frame member of the equipment rack; rotating a first handle of the first rack equipment removal tool about a first rotation shaft configured to couple the first handle to a first sliding-housing channel of a first housing of the first rack equipment removal tool; and rotating a second handle of the second rack equipment removal tool about a second rotation shaft configured to couple the second handle to a second sliding-housing channel of a second housing of the second rack equipment removal tool. The rotation of the first handle and the second handle causes the movement of the first hook and the second hook, respectively, to partially remove the power module from the equipment rack.

### BRIEF DESCRIPTION OF THE DRAWINGS

The accompanying drawings are not intended to be drawn to scale. In the drawings, each identical or nearly identical component that is illustrated with various figures, is represented by a line numeral. For purposes of clarity, not every component may be labeled in every drawing. In the drawings:
FIG. 1 is a perspective view of a device of an embodiment of the present disclosure for removing a power module from an IT equipment rack;
FIG. 2 is an exploded perspective view of the device;
FIG. 3 is a plan view of the device in a first, pre-operational position, according to an example;
FIG. 4 is a plan view of the device in a second, operational position, according to an example;
FIG. 5 is an enlarged perspective view of an end of the device showing aspects of the device, according to an example;
FIG. 6 is another enlarged perspective view of the end of the device showing aspects of the device, according to an example;
FIG. 7 is an elevational view showing two devices secured to a power module in respective pre-operational positions, according to an example; and
FIG. 8 is an elevational view showing the two devices in respective operational positions thereby moving the power module out of a mounting slot of the IT equipment rack, according to an example.

### DETAILED DESCRIPTION OF THE DISCLOSURE

Embodiments of the present disclosure are directed to a device or tool used to assist an operator to remove a power module, or some other type of heavy IT equipment, from a mounting slot of an IT equipment rack. In one embodiment, the device includes a housing having a rotation shaft and a handle coupled to the rotation shaft and configured to rotate with respect to the housing about the rotation shaft. The device further includes a hook having a first arm coupled to the handle and a second arm including a hook fastener configured to be coupled to a power module. The device further includes a frame mounting fastener coupled to the housing. The frame mounting fastener is configured to be coupled to a frame of an equipment rack supporting the power module. The arrangement is such that when securing the hook fastener to the power module and the frame mounting fastener to the frame of the equipment rack, rotation of the handle causes the movement of the hook to partially remove the power module from the equipment rack.

Embodiments are not limited in their application to the details of construction and the arrangement of components set forth in the following description or illustrated in the drawings. Also, the phraseology and terminology used herein is for the purpose of description and should not be regarded as limiting. The use of "including," "comprising," or "having," "containing," "involving," and variations thereof herein, is meant to encompass the items listed thereafter and equivalents thereof as well as additional items.

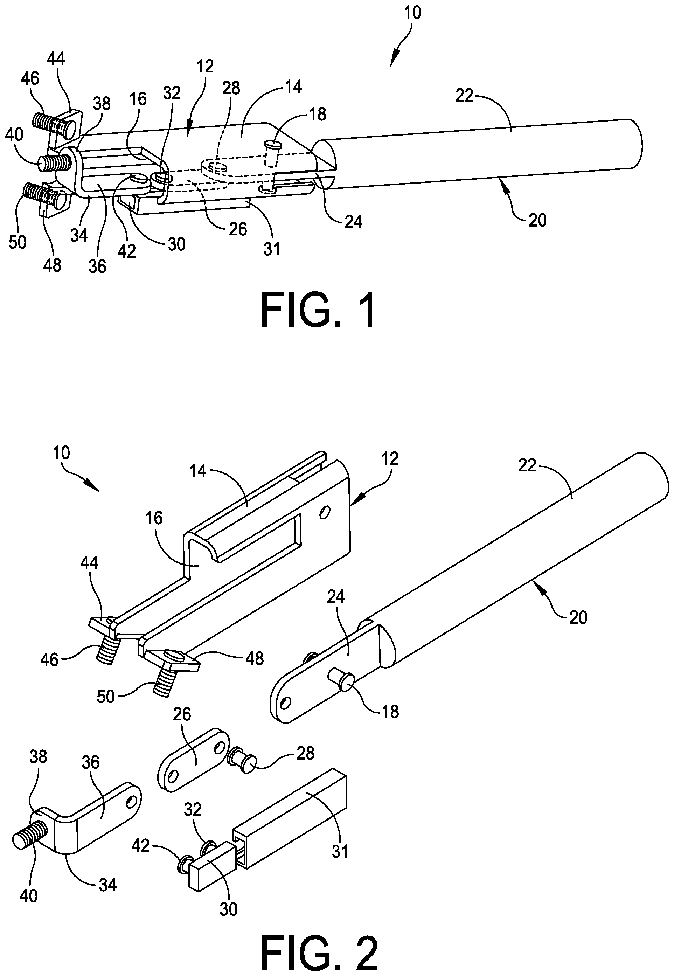

Referring to the drawings, and more particularly to FIGS. 1 and 2, a device of embodiments of the present disclosure is generally indicated at 10. The device 10 sometimes may be referred to herein as a tool. The device 10 is designed to assist an operator in partially removing a power module from a mounting slot of an IT equipment rack. Although aspects of the disclosure are directed to removing power modules from mounting slots of IT equipment racks, it should be understood that the device 10 may be configured to remove other types of IT equipment from mounting slots of IT equipment racks. Further, the device may be used to partially remove any type of equipment from a rack storage-type of support.

As shown, the device 10 includes a housing, generally indicated at 12, having a housing body 14 and a sliding-housing channel 16 formed in the housing body 14. In one embodiment, the housing body 14 of the housing 12 is a semi-circular structure having side walls that define the sliding-housing channel 16. The housing 12 further includes a rotation shaft 18 that extends through the sliding-housing channel 16 from one side wall of the housing body 14 to an opposite side wall of the housing body 14. In one embodiment, the ends of the rotation shaft 18 are secured to walls of the housing body 14 by staking, which is a process of connecting two components, e.g., the side wall of the housing body 14 and the rotation shaft 18, by creating an interference fit. For example, each side wall of the housing body 14 may include an opening, which are aligned with one another, and the rotation shaft 18 may be sized to fit within the within the openings. A staking punch then may be used to expand each end of the rotation shaft 18, sometimes referred to as a boss or boss end, to expand the end radially and compress the end axially to form an interference fit between the side wall of the housing body 14 and the rotation shaft 18. Other methods of permanently securing the rotation shaft 18 to the side walls of the housing body 14 may be employed, such as welding.

The device 10 further includes a handle, generally indicated at 20, having a relatively large diameter first portion 22 configured to be gripped by an operator and a relatively thin second portion 24 that extends from the first portion 22 and is configured to be received within the sliding-housing channel 16 of the housing body 14 of the housing 12. The rotation shaft 18 is configured to secure the second portion 24 of the handle 20 to the housing body 14 of the housing 12, with the rotation shaft 18 extending through an opening formed in the second portion 24 of the handle 20. The manner in which the second portion 24 of the handle 20 is secured to the side walls of the housing body 14 by the rotation shaft 18 enables the rotation of the handle 20 with respect to the housing 12 about the rotation shaft 18. The rotation shaft 18 is secured to the side walls of the housing body 14 of the housing 12 after the rotation shaft 18 is positioned within the opening of the second portion 24 of the handle 20. In one embodiment, the housing 12 and the handle 20, as well as other components of the device 10, are fabricated from a suitable metal material, e.g., stainless steel.

The device 10 further includes a moving link 26 disposed within the sliding-housing channel 16 of the housing body 14 and coupled to the handle 20. Specifically, the moving link 26 is sized to fit within the sliding-housing channel 16 and move within the sliding-housing channel 16. As shown, the second portion 24 of the handle 20 is pivotally coupled to the moving link 26 by a connection shaft 28, which is suitably pivotally secured to the second portion 24 of the handle and the moving link 26. The arrangement is such that the moving link 26 is configured to move within the sliding-housing channel 16 when rotating the handle 20. The arrangement is such that the moving link 26 is configured to rotate and move linearly within the sliding-housing channel 16 when rotating the handle 20. The manner in which the connection shaft 28 is secured to the second portion 24 of the handle 20 to the moving link is similar to the manner in which the second portion 24 of the handle 20 is secured to the housing body 14 of the housing 12 by the rotation shaft. As shown, the moving link includes two openings formed therein, one of which is used to receive the connection shaft 28 therethrough.

The device 10 further includes a moving block 30 that is coupled to the moving link 26 by a first pin 32, which is suitably secured to the moving link 26 and the moving block 30. Specifically, the first pin 32 extends through the other opening of the two openings formed in the moving link 26, with one end of the first pin 32 being fixedly secured to the moving block 30 and the other end of the first pin 32 being secured to the moving link 26. As with the moving link 26, the moving block 30 is configured to move within the sliding-housing channel 16 when rotating the handle 20 to move the moving link 26. The arrangement is such that the moving block 30 is configured to move linearly within the sliding-housing channel 16 when rotating the handle 20.

In one embodiment, as best shown in FIG. 2, the moving block 30 is disposed in a moving block housing 31, which is provided within the sliding-housing channel 16 of the housing body 14 of the housing 12. The moving block housing 31 enables the moving block 30 to move linearly with respect to the housing 12 when rotating the handle 20.

The device 10 further includes a hook 34 having a first arm 36 coupled to the second portion 24 of the handle 20 by the moving block 30 and the moving link 26 and a second arm 38 having a hook fastener 40 configured to be coupled to a power module. The first arm 36 and the second arm 38 are sometimes referred to as the first end and the second end, respectively. As shown, the first arm 36 of the hook 34 is coupled to the moving block 30 by a second pin 42, which is suitably secured to the moving block 30 and the first arm 36 of the hook 34. Specifically, the second pin 42 extends through an opening formed in the first arm 36 of the hook 34, with one end of the second pin 42 being fixedly secured to the moving block 30 and the other end of the second pin 42 being secured to the first arm 36 of the hook 34. The arrangement is such that the hook 34 is configured to move linearly within the sliding-housing channel 16 when rotating the handle 20

The second portion 24 of the handle 20, the moving link 26, and the moving block 30 are configured to move the hook 34 in a linear direction within the sliding-housing channel 16 of the housing body 14 of the housing 12 when rotating the first portion 22 of the handle 20 with respect to the housing 12. Specifically, when rotating the handle 20, the second portion 24 of the handle 20 rotates about the fixed rotation shaft 18, thereby rotating the moving link 26 about the connection shaft 28. The rotation of the moving link 26 about the connection shaft 28 causes the linear movement of the moving link 26 and the moving block 30 within the sliding-housing channel 16 of the housing body 14 of the housing 12. The movement of the moving block 30 linearly within the sliding-housing channel 16 causes the linear movement of the hook 34 from a position substantially outside the sliding-housing channel 16 of the housing body 14 to a position substantially within the sliding-housing channel 16 of the housing body 14.

It should be understood that the linkage shown in FIGS. 1 and 2, i.e., the moving link 26 and the moving block 30, is but one way to linearly move the hook 34 within the sliding-housing channel 16 of the housing body 14 of the housing 12. Other types of linkages and/or movement mechanisms may be provided to achieve the movement of the hook 34 within the sliding-housing channel 16.

As mentioned, the second arm 38 of the hook 34 includes the hook fastener 40, which is releasably secured to the power module. In one embodiment, the first arm 36 of the hook 34 is secured to the moving block 30 by the second pin 42 and the second arm 38 extends perpendicularly from the first arm 36 of the hook 34. The hook fastener 40 extends from the second arm 38 perpendicularly from the first arm 36 through an opening formed in the second arm 38 of the hook 34. The hook fastener 40 of the hook 34 includes a threaded fastener that is configured to be rotated with respect to the second arm 38 of the hook 34 to enable the hook fastener to be secured to the power module. The other end of the hook fastener 40 is configured to be threadably received within a threaded opening formed in a flange of the power module, which will be described in greater detail below. It should be noted that other types of fasteners may be provided to secure the hook 34 to the power module.

The housing 12 is configured to be fixedly secured to a frame of the IT equipment rack so that the rotation of the handle 20 with respect to the housing 12 causes the movement of the hook 34 to partially remove the power module from the equipment rack. Specifically, in one embodiment, the housing body 14 of the housing 12 includes a first tab portion 44 configured to receive a first frame mounting fastener 46 and a second tab portion 48 spaced vertically from the first tab portion 44. The second tab portion 48 is configured to receive a second frame mounting fastener 50. As shown, each of the first tab portion 44 and the second tab portion 48 extends along a plane that is angled with respect to a direction of the housing body 14 of the housing 12. In one embodiment, each of the first tab portion 44 and the second tab portion 48 extends along a plane that is angled a 45-degrees with respect to a direction of the housing body 14 of the housing 12. It should be noted that the tab portions 44, 48 may be disposed at different angles so long as the housing 12 of the device 10 is capable of being fixedly secured to the frame of the IT equipment rack. In one embodiment, the first frame mounting fastener 46 and the second frame mounting fastener 50 are threaded bolts, with ends of the first frame mounting fastener 46 and the second frame mounting fastener 50 threadably receiving fastening nuts to secure the housing 12 to the frame of the IT equipment rack.

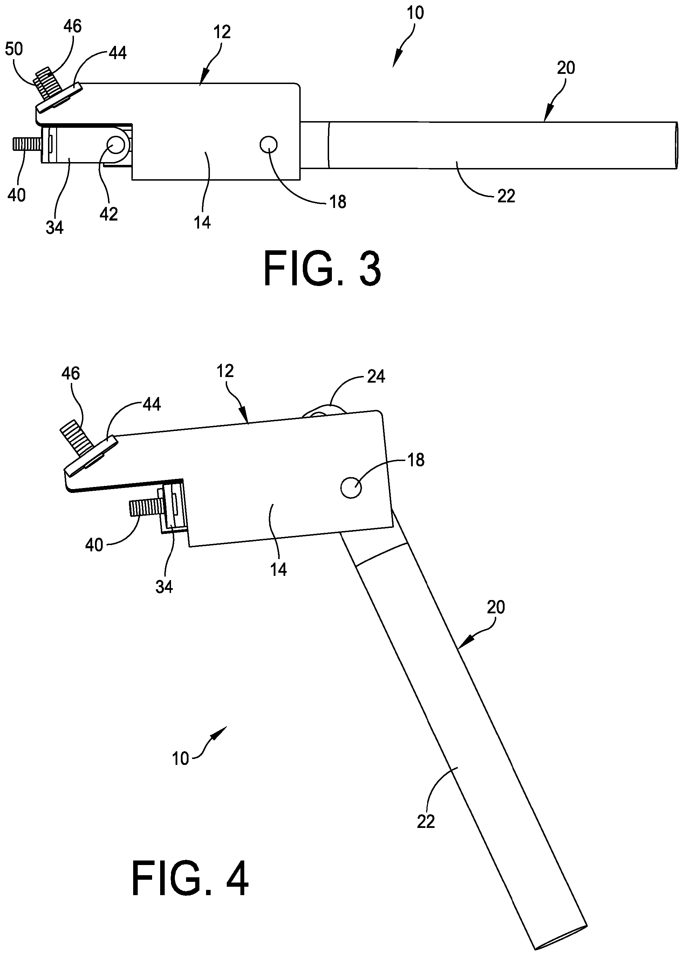

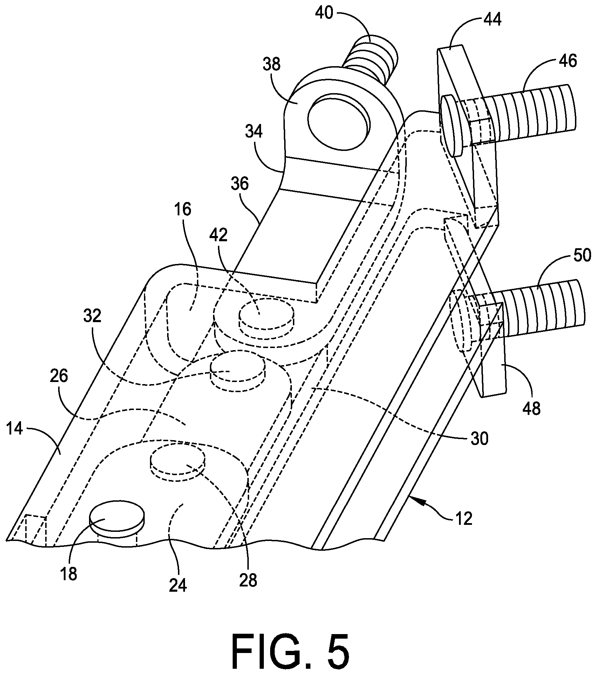

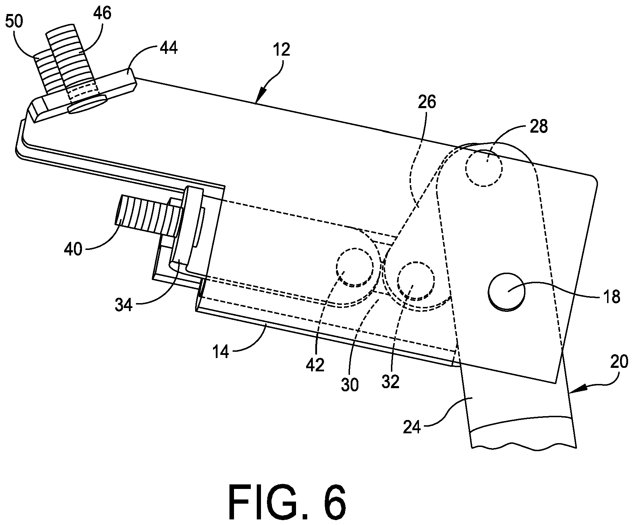

Referring to FIGS. 3 and 5, the handle 20 is shown in a first, pre-operational position, with the first portion 22 of the handle 20 extended along a common axis of the housing body 14 of the housing 12. As shown, the hook 34 is extended with the hook fastener 40 extending beyond an outer end of the housing body 14 of the housing 12. Referring to FIGS. 4 and 6, the handle 20 is shown in a second, operational position, with the first portion 22 of the handle 20 rotated with respect to the housing body 14 of the housing 12. As shown, the hook 34 is retracted within the sliding-housing channel 16 of the housing body 14 of the housing 12, with the hook fastener 40 being moved linearly within the sliding-housing channel 16. The movement of the hook 34 causes the movement of the power module from the mounting slot of the IT equipment rack.

In some embodiments, movement of the handle 20 from the first position to the second position, in which the handle 20 is almost perpendicular (90-degrees) with respect to the housing body 14 of the housing 12, causes the hook 34 to move a relatively nominal distance, such as a distance of 30 millimeters (mm). It should be understood that the device can be configured to move the hook 34 a desired distance, including up to 50 mm. Specifically, the space between the rotation shaft 18 and the connection shaft 28 on the second portion 24 of the handle 20 can be varied to manipulate the amount of distance moved by the hook 34. This amount of distance enables an operator to firmly secure the power module to manually remove the power module from the mounting slot of the IT equipment rack.

In operation, the hook fastener 40 of the hook 34 of the device 10 is secured to a front panel of a power module, the frame mounting fasteners 46, 50 are secured to a frame member of an IT equipment rack, and the handle 20 is rotated to the second position shown in FIG. 4 to move the hook 34 as shown in FIG. 6 to partially remove the power module from the mounting slot of the IT equipment rack. As noted, the power module is configured to be removed from the mounting slot a distance of 30 millimeters (mm). Once partially removed, the hook fastener 40 and the first and second frame mounting fasteners 46, 50 are removed and the operator is able to completely remove the entire power module from the mounting slot of the IT equipment rack.

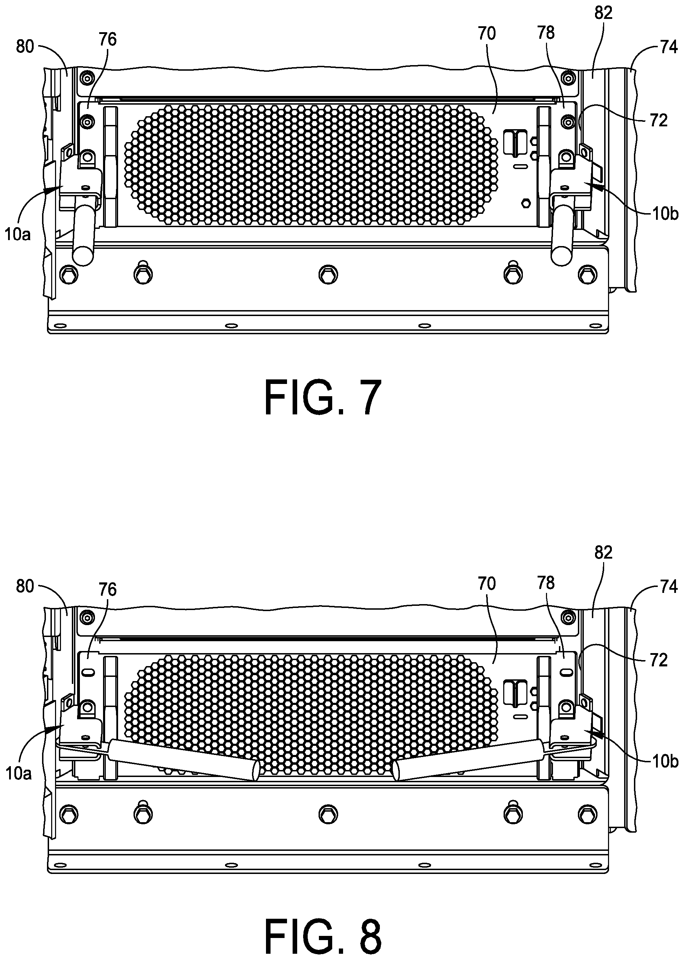

Referring to FIGS. 7 and 8, a method of removing a power module 70 from a mounting slot 72 of an equipment rack 74 is shown and will be described below. The power module 70 is disposed within the mounting slot 72 of the IT equipment rack 74. As shown, the method includes securing a first hook of a first rack equipment removal device, indicated at 10a, to a first flange 76 of the power module 70 and securing a second hook of a second rack equipment removal device, indicated at 10b, to a second flange 78 of the power module 70. The method further includes securing a first frame mounting fastener and a second frame mounting fastener of the first rack equipment removal device 10a to a first frame member 80 of the IT equipment rack 74 and securing a first frame mounting fastener and a second frame mounting fastener of the second rack equipment removal device 10b to a second frame member 82 of the equipment rack 74. FIG. 7 illustrates a handle of the first rack equipment removal device 10a and a handle of the second rack equipment removal device 10b in extended, pre-operational positions.

The method further includes simultaneously rotating the handle of the first rack equipment removal device 10a about a rotation shaft configured to couple the handle to a sliding-housing channel of a housing of the first rack equipment removal device 10a and rotating a handle of the rack equipment removal device 10b about a rotation shaft configured to couple the handle to a sliding-housing channel of a housing of the second rack equipment removal device 10b. As shown in FIG. 8, the rotation of the handles causes the movement of the hooks of the first and second rack equipment removal devices 10a, 10b, respectively, to partially remove the power module 70 from the mounting slot 72 of the equipment rack 74.

In some embodiments, the device 10 uses a rotation mechanism and screw-locking mechanism to help saving effort to pull out a heavy power module from an IT equipment rack.

In some embodiments, the device 10 uses a rotation and moving mechanism, with the principle of increasing the torque to reduce the horizontal pulling force. The device 10 is configured to be used with a power module. The device 10 is lightweight, low cost and easy to carry.

In some embodiments, a rack equipment removal device or tool is configured to be fastened to a power module and to an IT equipment rack frame by a hook. The device has a handle connected to a housing, where the handle is rotated about its shaft and a moving link is connected to a moving block to move the hook.

Having thus described several aspects of at least one embodiment, it is to be appreciated that various alterations, modifications, and improvements will readily occur to those skilled in the art. Such alterations, modifications, and improvements are intended to be part of this disclosure, and are intended to be within the scope of the disclosure. Accordingly, the foregoing description and drawings are by way of example only.

Further embodiments are described below.
Clause 1. A rack equipment removal tool, comprising:
   a handle;
   a housing including a rotation shaft, the handle being coupled to the rotation shaft and configured to rotate with respect to the housing about the rotation shaft;
   a hook including a first end coupled to the handle and a second end having a fastener configured to be coupled to a power module; and
   a frame mounting fastener coupled to the housing, the frame mounting fastener being configured to be coupled to a frame of an equipment rack supporting the power module,
   wherein rotation of the handle causes the movement of the hook to partially remove the power module from the equipment rack.
Clause 2. The rack equipment removal tool of clause 1, wherein the housing further includes a sliding-housing channel.
Clause 3. The rack equipment removal tool of clause 2, further comprising a moving link coupled to the handle and coupled to a moving block, the moving link being configured to move within the sliding-housing channel.
Clause 4. The rack equipment removal tool of clause 3, wherein the handle includes a first portion configured to be gripped by an operator and a second portion that extends from the first portion and is configured to be received within the sliding-housing channel.
Clause 5. The rack equipment removal tool of clause 4, wherein the second portion of the handle is pivotally coupled to the moving link by a connection shaft.
Clause 6. The rack equipment removal tool of clause 5, wherein the moving link is coupled to the moving block by a first pin.
Clause 7. The rack equipment removal tool of clause 6, wherein the first end of the hook is coupled to the moving block by a second pin.
Clause 8. The rack equipment removal tool of clause 1, wherein the fastener of the hook includes a threaded fastener configured to be threadably received within a threaded opening formed in a flange of the power module.
Clause 9. The rack equipment removal tool of clause 1, wherein the housing includes a first tab portion configured to receive the frame mounting fastener.
Clause 10. The rack equipment removal tool of clause 9, wherein the first tab portion extends along a plane that is angled with respect to a direction of the housing.
Clause 11. The rack equipment removal tool of clause 9, wherein the housing further includes a second tab portion spaced from the first tab portion, the second tab portion being configured to receive another frame mounting fastener.
Clause 12. The rack equipment removal tool of clause 11, wherein each of the first tab portion and the second tab portion extends along a plane that is angled with respect to a direction of the housing.
Clause 13. A method of removing a power module from an equipment rack, the method comprising:
   securing a hook of a rack equipment removal tool to the power module;
   securing a frame mounting fastener of the rack equipment removal tool to the equipment rack; and
   rotating a handle of the rack equipment removal tool about a rotation shaft configured to couple the handle to a sliding-housing channel of a housing of the rack equipment removal tool, the rotation of the handle causing the movement of the hook to partially remove the power module from the equipment rack.
Clause 14. The method of clause 13, wherein rotating the handle further causes movement of a moving link that is coupled to the handle and coupled to a moving block of the rack equipment removal tool, the hook being coupled to the moving block.
Clause 15. The method of clause 14, wherein the handle includes a first portion configured to be gripped by an operator and a second portion that extends from the first portion and is configured to be received within the sliding-housing channel.
Clause 16. The method of clause 15, further comprising pivotally coupling the second portion of the handle to the moving link by a connection shaft, pivotally coupling the moving link to the moving block by a first pin, and pivotally coupling the first end of the hook to the moving block by a second pin.
Clause 17. The method of clause 12, wherein the fastener of the hook includes a threaded fastener configured to be threadably received within a threaded opening formed in a flange of the power module.
Clause 18. The method of clause 17, wherein the housing includes a first tab portion configured to receive the frame mounting fastener, and a second tab portion spaced from the first tab portion, the second tab portion being configured to receive another frame mounting fastener.
Clause 19. The method of clause 18, wherein each of the first tab portion and the second tab portion extends along a plane that is angled with respect to a direction of the housing.
Clause 20. A method of removing a power module from an equipment rack, the method comprising:
   securing a first hook of a first rack equipment removal tool to a first flange of the power module;
   securing a second hook of a second rack equipment removal tool to a second flange of the power module;
   securing a first frame mounting fastener of the first rack equipment removal tool to a first frame member of the equipment rack;
   securing a second frame mounting fastener of the second rack equipment removal tool to a second frame member of the equipment rack;
   rotating a first handle of the first rack equipment removal tool about a first rotation shaft configured to couple the first handle to a first sliding-housing channel of a first housing of the first rack equipment removal tool; and
   rotating a second handle of the second rack equipment removal tool about a second rotation shaft configured to couple the second handle to a second sliding-housing channel of a second housing of the second rack equipment removal tool,
   wherein the rotation of the first handle and the second handle causes the movement of the first hook and the second hook, respectively, to partially remove the power module from the equipment rack.

## Claims

1. A rack equipment removal tool (10), comprising:
a handle (20);
a housing (12) including a rotation shaft (18), the handle being coupled to the rotation shaft (18) and configured to rotate with respect to the housing (12) about the rotation shaft (18);
a hook (34) including a first end (36) coupled to the handle (20) and a second end (38) having a fastener (40) configured to be coupled to a power module (70); and
a frame mounting fastener (46) coupled to the housing (12), the frame mounting fastener (46) being configured to be coupled to a frame of an equipment rack (74) supporting the power module (70),
wherein rotation of the handle (20) causes the movement of the hook (34) to partially remove the power module (70) from the equipment rack (74).

2. The rack equipment removal tool (10) of claim 1, wherein the housing (12) further includes a sliding-housing channel (16).

3. The rack equipment removal tool (10) of claim 2, further comprising a moving link (26) coupled to the handle (20) and coupled to a moving block (30), the moving link (26) being configured to move within the sliding-housing channel (16).

4. The rack equipment removal tool (10) of claim 3, wherein the handle (20) includes a first portion (22) configured to be gripped by an operator and a second portion (24) that extends from the first portion (22) and is configured to be received within the sliding-housing channel (16).

5. The rack equipment removal tool (10) of claim 4, wherein the second portion (24) of the handle (20) is pivotally coupled to the moving link (26) by a connection shaft (28).

6. The rack equipment removal tool (10) of claim 5, wherein the moving link (26) is coupled to the moving block (30) by a first pin (32).

7. The rack equipment removal tool (10) of claim 6, wherein the first end (36) of the hook (34) is coupled to the moving block (30) by a second pin (42).

8. The rack equipment removal tool (10) of any of claims 1 to 7, wherein the fastener (40) of the hook (34) includes a threaded fastener configured to be threadably received within a threaded opening formed in a flange of the power module (70).

9. The rack equipment removal tool (10) of any of claims 1 to 8, wherein the housing (12) includes a first tab portion (44) configured to receive the frame mounting fastener (46) .

10. The rack equipment removal tool (10) of claim 9, wherein the housing (12) further includes a second tab portion (48) spaced from the first tab portion (44), the second tab portion (48) being configured to receive another frame mounting fastener (50).

11. The rack equipment removal tool (10) of claim 9 or 10, wherein any or both of the first tab portion (44) and the second tab portion (48) extends along a plane that is angled with respect to a direction of the housing (12).

12. A method of removing a power module (70) from an equipment rack (74), the method comprising:
securing a hook (34) of a rack equipment removal tool (10) to the power module (70);
securing a frame mounting fastener (46) of the rack equipment removal tool (10) to the equipment rack (74); and
rotating a handle (20) of the rack equipment removal tool (10) about a rotation shaft (18) configured to couple the handle (20) to a sliding-housing channel (16) of a housing (12) of the rack equipment removal tool (10), the rotation of the handle (20) causing the movement of the hook (34) to partially remove the power module (70) from the equipment rack (74).

13. The method of claim 12, wherein the rack equipment removal tool (10) is according to any of claims 1 to 11.

14. The method of claim 12 or 13, wherein rotating the handle (20) further causes movement of a moving link (26) that is coupled to the handle (20) and coupled to a moving block (30) of the rack equipment removal tool (10), the hook being coupled to the moving block (30).

15. The method of any of claims 12 to 14, wherein the rack equipment removal tool is a first rack equipment removal tool (10a), the method comprising:
securing a first hook of the first rack equipment removal tool (10a) to a first flange (76) of the power module (70);
securing a first frame mounting fastener of the first rack equipment removal tool (10a) to a first frame member (80) of the equipment rack (74);
rotating a first handle of the first rack equipment removal tool (10a) about a first rotation shaft configured to couple the first handle to a first sliding-housing channel of a first housing of the first rack equipment removal tool (10a);
wherein the method further comprises:
securing a second hook of a second rack equipment removal tool (10b) to a second flange (78) of the power module (70);
securing a second frame mounting fastener of the second rack equipment removal tool (10b) to a second frame member (82) of the equipment rack (74);
rotating a second handle of the second rack equipment removal tool (10b) about a second rotation shaft configured to couple the second handle to a second sliding-housing channel of a second housing of the second rack equipment removal tool (10b), and
wherein the rotation of the first handle and the second handle causes the movement of the first hook and the second hook, respectively, to partially remove the power module (70) from the equipment rack (74).
